# EUROPEAN PATENT APPLICATION

(11) **EP 1 814 123 A1**
(43) Date of publication of application: **01.08.2007**
(21) Application number: 07100693.6
(22) Date of filing: 17.01.2007
(51) Int. Cl.: G11C 16/04

(54) **Nand-type nonvolatile memory device having common bit lines and methods of operating the same**

(30) Priority: 26.01.2006 KR 20060008240; 10.03.2006 KR 20060022802
(71) Applicant: Samsung Electronics Co., Ltd., Yeongtong-gu Suwon-si, Gyeonggi-do (KR)
(72) Inventor: Kim, Suk-pil c/o Samsung Advanced Institute of Technology, Gyeonggi-do (KR); Park, Yoon-dong c/o Samung Advanced Institute of Technology, Gyeonggi-do (KR); Kim, Won-joo c/o Samsung Advanced Institute of Technology, Gyeonggi-do (KR); Lee, Jung-hoon c/o Samsung Advanced Institute of Technology, Gyeonggi-do (KR); Hyun, Jae-woong c/o Samsung Advanced Institute of Technology, Gyeonggi-do (KR)
(74) Representative: Greene, Simon Kenneth

(57) **Abstract**

A NAND-type nonvolatile memory device includes a first string and a second string. The ends of each of the first and second strings are connected to a common bit line and a common source line, respectively. Each of the first string and the second string have a string selection transistors, a plurality of unit devices and a source selection transistor. Word lines are respectively connected to control gates of the unit devices in the same rows. A first string selection line and a second string selection line are respectively connected to the gates of the string selection transistors of the first string and the second string. A first source selection line and a second source selection line are respectively connected to the gates of the first string and the second string.

## Description

### BACKGROUND

As related art semiconductor devices become smaller, they must also process an increasing volume of data. Processing an increasing volume of data may require higher operating speeds and/or higher integration of nonvolatile semiconductor memory devices. For example, operating speeds of a Fin-Field Effect Transistor (Fin-FET) may be increased by increasing the area of the channel, while the integration of the Fin-FET may be increased by decreasing the width of the Fin.

Related art nonvolatile semiconductor memory devices may include, for example, a Fin-FET and a Fin memory cell or a Fin-FET including a fin formed on an insulating layer. However, forming a lower resistance bit line contact may be more difficult in these related art Fin-FETs. For example, the Fin-FET including a Fin-FET and a Fin memory cell may include bit line contacts traversing multiple fins. In this example, the fins contact only the narrow upper surfaces of the bit line contacts, often resulting in excessive bit line contact resistance. Moreover, forming these related art Fin-FETs may be more difficult because the fins must be bent when forming the bit line contact.

In a related art Fin-FET including a fin formed on an insulating layer, source and drain regions connecting to the fins may be relatively wide to provide sufficient contact areas. However, this increases spaces between the fins, which lowers the Fin-FET integration.

### SUMMARY

Example embodiments relate to semiconductor devices, for example, NAND-type nonvolatile memory devices and methods of operating the same. At least one example embodiment provides a NAND-type nonvolatile memory device with a lower or relatively low contact resistance and/or higher or relatively high level of integration.

At least one other example embodiment provides a method of more reliably operating a nonvolatile memory device.

In a first aspect there is provided a non-volatile memory device according to claim 1. At least one example embodiment provides a NAND-type nonvolatile memory device including a first string and a second string. The first string may include string selection transistors, a plurality of unit devices and source selection transistors connected in series. Each of the plurality of unit devices may have a control gate and a storage node. Each of the string selection transistors and the source selection transistors may have a gate. The second string may include string selection transistors, a plurality of unit devices and source selection transistors connected in series. Each of the plurality of unit devices may have a control gate and a storage node. Each of the string selection transistors and the source selection transistors may have a gate. A plurality of word lines may be connected to corresponding control gates of the plurality of unit devices located on the same rows of the first string and the second string, and may traverse the first string and the second string. A first string selection line may be connected to the gate of the string selection transistor of the first string and may traverse the first string. A second string selection line may be connected to the gate of the string selection transistor of the second string and may traverse the second string. A common bit line may be located on an outer side of the string selection transistor of the first string and the string selection transistor of the second string and may connect one end of each of the first string and the second string. A first source selection line may be connected to the gate of the source selection transistor of the second string, and may traverse the second string. A second source selection line may be connected to the gate of the source selection transistor of the first string, and may traverse the first string. A common source line may be located on an outer side of the source selection transistor of the first string and the source selection transistor of the second string, and may connect the other end of each of the first string and the second string.

At least one other example embodiment provides a NAND-type nonvolatile memory device having unit devices of a NAND cell array structure. The unit devices may be located within a plurality of strings, and each may include a control gate and a storage node. A plurality of common bit lines may be commonly connected respectively to one end of each of pairs of adjacent strings out of the plurality of strings. String selection transistors may be included between the unit devices of the plurality of strings and the common bit lines, and may include gates. A first string selection line may be connected to the gates of the string selection transistors of one string out of each pair of strings respectively connected to the plurality of common bit lines. A second string selection line may be connected to the gates of the string selection transistors of the other string out of each pair of strings respectively connected to the plurality of common bit lines. A plurality of common source lines may be commonly connected respectively to the other end of each of the pairs of adjacent the strings out of the plurality of strings. A source selection transistors may be arranged between the unit devices of the plurality of strings and the common source lines, and each source selection transistor may include a gate. A first source selection line may be connected to the gates of the source selection transistors of the other string out of each pair of the strings respectively connected to the plurality of common bit lines. A second source selection line may be connected to the gates of the source selection transistors of the one string out of each pair of the strings respectively connected to the plurality of common bit lines. Also, a plurality of word lines may be respectively connected to the control gates of the unit devices located in the same rows of the NAND cell array structure.

In another aspect there is provided a method of operating a non-volatile memory device according to claim 14. At least one other example embodiment provides a method of operating the NAND-type nonvolatile memory device. When programming, data may be selectively stored in one of the plurality of unit devices of either the first string or the second string, and the stored data may be read out during a read operation.

The programming may include supplying a first voltage to a channel of the plurality of unit devices of one string, and supplying a second voltage to a channel of the plurality of unit devices of the other string. The first voltage may be lower than the second voltage. Also, a program voltage may be supplied to the word line connected to the gate of the single unit device, and a pass voltage may be supplied to the word lines connected to the gates of the other unit devices. In this example embodiment, the first voltage may allow programming of the plurality of unit devices of one string, and the second voltage may suppress and/or prevent programming of the plurality of unit devices of the other strings.

The read operation may include supplying the second voltage to either one of the common bit line or the common source line, and supplying the first voltage to the other one. The turn-on voltage may be supplied to the string selection line connected to the gate of the string selection transistor of the one string out of the first and second string selection lines, and the turn-off voltage may be supplied to the other string selection line. The turn-on voltage may be supplied to the source selection line connected to the gate of the source selection transistor of the one string out of the first and second source selection lines, and the turn-off voltage may be supplied to the other source selection line. The turn-off voltage may be supplied to the string selection line connected to the gate of the string selection transistor of the other strings and to the source selection line connected to the gate of the source selection transistor. Also, a read voltage may be supplied to the word line connected to the gate of one unit device of the one string, and a pass voltage may be supplied to the word lines connected to the gates of the other unit devices.

At least one other example embodiment provides a method of operating the NAND-type nonvolatile memory device. The programming may include selectively storing data in one unit device of the plurality of unit devices of one string out of the plurality of strings, and reading the data stored in the one unit device.

### BRIEF DESCRIPTION OF THE DRAWINGS

Example embodiments will become more apparent by describing in detail the example embodiments shown in the attached drawings in which:
FIG. 1 is a circuit diagram illustrating a NAND-type nonvolatile memory device, according to an example embodiment;
FIG. 2 is a circuit diagram illustrating a NAND-type nonvolatile memory device, according to another example embodiment;
FIG. 3 is a circuit diagram illustrating a method of programming a NAND-type nonvolatile memory device, according to an example embodiment; and
FIG. 4 is a circuit diagram illustrating a method of reading a NAND-type nonvolatile memory device, according to an example embodiment.

### DETAILED DESCRIPTION OF EXAMPLE EMBODIMENTS

Various example embodiments of the present invention will now be described more fully with reference to the accompanying drawings in which some example embodiments of the invention are shown. In the drawings, the thicknesses of layers and regions are exaggerated for clarity.

Detailed illustrative embodiments of the present invention are disclosed herein. However, specific structural and functional details disclosed herein are merely representative for purposes of describing example embodiments of the present invention. This invention may, however, may be embodied in many alternate forms and should not be construed as limited to only the embodiments set forth herein.

Accordingly, while example embodiments of the invention are capable of various modifications and alternative forms, embodiments thereof are shown by way of example in the drawings and will herein be described in detail. It should be understood, however, that there is no intent to limit example embodiments of the invention to the particular forms disclosed, but on the contrary, example embodiments of the invention are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between", "adjacent" versus "directly adjacent", etc.).

The terminology used herein is for the purpose of describing particular embodiments only and is not intended to be limiting of example embodiments of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

A nonvolatile memory device according to example embodiments discussed herein are provided as an example of an EEPROM device, a flash memory device or a Silicon-Oxide-Nitride-Oxide-Silicon (SONOS) memory device. The nonvolatile memory device has a NAND structure.

Nonvolatile memory devices, according to at least some example embodiments, may be applied to a Fin-FET or Fin memory device, but is not limited thereto. For example, nonvolatile memory devices may be applied to a planar type memory device, a recess-type memory device and other memory devices.

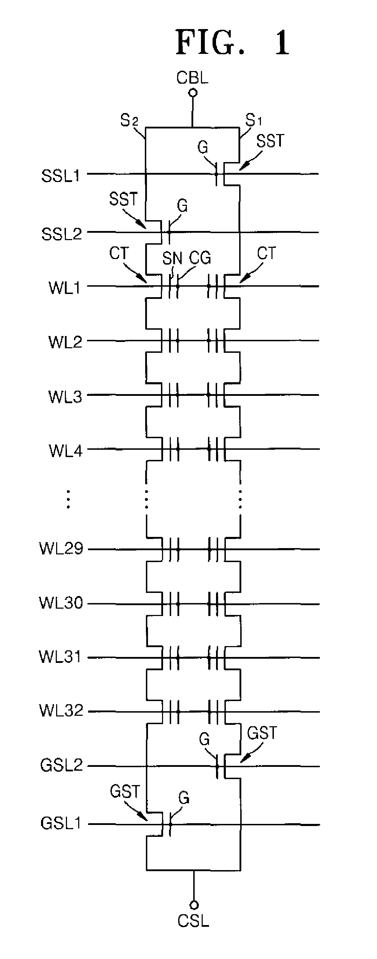

FIG. 1 is a circuit diagram illustrating a NAND-type nonvolatile memory device, according to an example embodiment.

Referring to FIG. 1, the NAND-type nonvolatile memory device may include a pair of first and second strings S1 and S2. The first and second strings S1 and S2 may be connected to a common bit line CBL at one end, and to a common source line CSL at the other end. Each of the first string S1 and the second string S2 may include a plurality of unit devices CT, a string selection transistor SST and/or a source selection transistor GST. The plurality of unit devices CT may be arranged in a matrix to form a NAND cell array structure.

The common bit line CBL may be located outside the string selection transistors SST of the first string S1 and the second string S1. A signal from the common bit line CBL may be selectively applied to (e.g., separated in) each string unit by controlling the string selection transistors SST. When compared to related art individual bit line structures, the common bit line CBL, according to example embodiments, may have a greater area. Therefore, the common bit line CBL may have a low, lower, relatively low or significantly lower resistance, which may allow the strings S1 and S2 to be arranged more closely. As a result, the integration of the nonvolatile memory device may improve.

The common source line CSL may be located outside the source selection transistors GSL of the first string S1 and the second string S2. A signal of the common source line CSL may be selectively applied to (e.g., separated in) each string unit by controlling the source selection transistors GST. This common source line CSL structure may enhance integration of the nonvolatile memory device together with the common bit line CBL structure.

In the first string S1, the string selection transistor SST, the plurality of unit devices CT and the source selection transistor GST may be connected in series. In FIG. 1, the number of unit devices CT shown is for illustrative purposes, but does not limit scope. Each string selection transistor SST may include a gate G. The gate G may switch the string selection transistor SST on and off. In at least one example embodiment, the string selection transistor SST may include a MOSFET.

The second string S2 may have a similar layout to the first string S1. For example, in the second string S2, the string selection transistor SST, the plurality of unit devices CT and the source selection transistor GST may be connected in series. The first string S1 may differ from the second string S2 in the arrangement of the string selection transistor SST and/or source selection transistor GST. For example, as shown in FIG. 1, the string selection transistor SST of the first string S1 and the second string S2 may be located in different rows. In addition, the source selection transistor GST of the first string S1 and the second string S2 may be located in different rows.

Each unit device CT may include a control gate CG and a storage node SN. The control gate CG may control the state of the storage node SN. The storage node SN may store or trap charge. For example, the unit devices CT may form a unit cell structure of a flash memory device, a Silicon-Oxide-Nitride-Oxide-Silicon (SONOS) memory device or any other suitable memory device.

A first string selection line SSL1 may be connected to a gate G of the string selection transistor SST of the first string S1, and may traverse the first string S1. A second string selection line SSL2 may be connected to a gate G of the string selection transistor SST of the second string S2, and may traverse the second string S2. For example, when the first string S1 and the second string S2 are arranged in a column direction, the first string selection line SSL1 and the second string selection line SSL2 may be arranged in a row direction. In this example, the first string selection line SSL1 and the second string selection line SSL2 may be located in different rows.

The first source selection line GSL1 may be connected to a gate G of the source selection transistor GST of the first string S1, and may traverse the first string S1. The second source selection line GSL2 may be connected to a gate G of the source selection transistor GST of the second string S2, and may traverse the second string S2. For example, when the first string S1 and the second string S2 are located in the column direction, the first source selection line GSL1 and the second source selection line GSL2 may be located in the row direction. In this example, the first source selection line GSL1 and the second source selection line GSL2 may be arranged in different rows.

A plurality of word lines WL1, WL2, WL3, WL4... WL29, WL30, WL31 and WL32 may be respectively connected to control gates CG of the unit devices CT located in the same rows as the first string S1 and the second string S2, and may traverse the first string S1 and the second string S2. For example, the first word line WL1 may be connected to the control gate CG of two unit devices CT in the third row, and the second word line WL2 may be connected to the control gate CG of two unit devices CT in the fourth row. The same rule may be applied to the other word lines WL3, WL4 ... WL29, WL30, WL31 and WL32. The number of word lines WL1, WL2, WL3, WL4... WL29, WL30, WL31 and WL32 may be determined by the arrangement of the unit devices CT, and is not limited to the number illustrated in FIG. 1.

A method of operating the nonvolatile memory device, according to an example embodiment will now be described. The operation of the nonvolatile memory device may include programming, reading and erasing (e.g., block erasing). When programming, data may be selectively stored in at least one of the plurality of unit devices CT of either one of the first string S1 or the second string S2. When reading, the stored data may be read from one or more of the plurality of unit devices. When block erasing, the data of the unit devices CT of the first string S1 and/or the second string S2 may be erased, for example, simultaneously.

A programming operation, according to an example embodiment, will now be described in more detail. Storing of data in the unit device CT of the fourth row connected to the second word line WL2 of the first string S1 will be discussed for example purposes. As discussed herein, a low voltage may refer to a lower, low, relatively low or substantially low voltage, and a high voltage may refer to a high, relatively high, higher or substantially higher voltage. The low voltage may also be referred to as the first voltage and the high voltage may be referred to as the second voltage.

In a programming operation, according to an example embodiment, a low voltage may be supplied to a channel of the unit devices CT of the first string S1, and a high voltage may be supplied to a channel of the unit devices CT of the second string S2. A program voltage may be supplied to the second word line WL2 connected to the gate G of the unit device CT in the fourth row of the first string S1. Also, a pass voltage may be supplied to the word lines WL1, WL3, WL4... WL29, WL30, WL31 and WL32 connected to the gates G of the other unit devices CT. A low negative voltage may be optionally supplied to the channel or a well region of the unit devices CT.

The low voltage may allow programming of the unit devices CT, and may be, for example, about 0V. The high voltage may be selected to suppress and/or prevent programming of the unit devices CT by channel boosting. The pass voltage may be selected as a voltage within a range that turns on the unit devices CT, but suppresses and/or prevents programming. The program voltage may be selected from within the range that programs a selected unit device CT by causing charge tunneling. In this example, the program voltage may be greater than the pass voltage.

Selecting the first string S1 by supplying the low voltage and the high voltage may be performed according to the following example. The high voltage may be supplied to the common bit line CBL, and the low voltage may be supplied to the common source line CSL. In this example, the first string selection line SSL1 and the first source selection line GSL1 may be supplied with a turn-off voltage. Also, the second string selection line SSL2 and the second source selection line GSL2 may be supplied with a turn-on voltage. The turn-on voltage may be selected within the range suitable for turning on the string selection transistor SST and the source selection transistor GST. The turn-off voltage may be suitable for turning of the string selection transistor SST and the source selection transistor GST (e.g., about 0V).

By doing so, the string selection transistor SST of the first string S1 may be turned off, and the source selection transistor GST of the first string S1 may be turned on. Consequently, the channel of the unit devices CT of the first string S1 may be electrically connected to the common source line CSL, and the low voltage may be supplied. The string selection transistor SST of the second string S2 may be turned on, and the source selection transistor GST of the second string S2 may be turned off. By doing so, the channel of the unit devices CT of the second string S2 may be electrically connected to the common bit line CBL, and therefore, the high voltage is supplied.

In another example, the low voltage may be supplied to the common bit line CBL, and the high voltage may be supplied to the common source line CSL. In this example, the turn-on voltage may be supplied to the first string selection line SSL1 and the first source selection line GSL1, and the turn-off voltage may be supplied to the second string selection line SSL2 and the second source selection line GSL2. Consequently, the channel of the unit devices CT of the first string S1 is electrically connected to the common bit line CBL, and the low voltage may be supplied accordingly. The channel of the unit devices CT of the second string S2 may be electrically connected to the common source line CSL, and thus, the high voltage is supplied. According to the programming operation, according to at least this example embodiment, the data may be selectively stored only in the unit device CT of the fourth row. In this example, the data may be stored in the form of charge in the storage node SN.

Similarly, in order to selectively store the data in the unit device CT of another row, for example, the 32nd row of the first string S1, the program voltage may be supplied to the 30^{th} word line WL30, and the pass voltage may be supplied to the other word lines WL1, WL2, WL3, WL4 ... WL29, WL31 and WL32. The same rule may be applied to programming the unit device CT of any other row.

The programming of the unit devices CT of the second string S2 may be performed in the same or substantially the same manner as the first string S1. For example, the low voltage may be supplied to the unit devices CT of the second string S2, and the high voltage may be supplied to the unit devices CT of the first string S1 to select the second string S2.

A reading operation, according to an example embodiment, will be described in more detail. Reading data of the unit device CT in the fourth row of the first string S1 will be discussed for example purposes. The high voltage may be supplied to the common bit line CBL or the common source line CSL, and the low voltage may be supplied to the other of the common bit line CBL and the common source line CSL to which the high voltage is not supplied. A turn-on voltage may be supplied to the first string selection line SSL1 and the second source selection line GSL2, and a turn-off voltage may be supplied to the second string selection line SSL2 and the first source selection line GSL1. By doing so, the string selection transistor SST and the source selection transistor GST of the first string S1 may turn on.

In addition, the string selection transistor SST and the source selection transistor GST of the second string S2 may turn off. A reading voltage may be supplied to the second word line WL2, and a pass voltage may be supplied to the other word lines WL1, WL3, WL4 ... WL29, WL30, WL31 and WL32. For example, the reading voltage may be less than the pass voltage. A low negative voltage may optionally be supplied to the channel or the well region of the unit devices CT.

Block erasing may be performed by supplying the erase voltage between the word lines WL1, WL2, WL3, WL4 ... WL29, WL30, WL31 and WL32 and well regions of the unit devices CT. For example, a negative voltage may be supplied to the word lines WL1, WL2, WL3, WL4 ... WL29, WL30, WL31 and WL32, and a greater negative voltage may be supplied to the well regions of the unit devices CT. By doing so, the charge stored in the storage nodes SN of the unit devices CT may be suppressed, prevented and/or eliminated.

As described above, nonvolatile memory devices, according to at least some example embodiments, employ the common bit line CBL and the common source line CSL structure to increase integration. Furthermore, methods of operating, according to at least some example embodiments, may separate string selection lines SSL1 and SSL2 and source selection lines GSL1 and GSL2 with respect to the strings S1 and S2, so that the strings S1 and S2 may be individually and/or more reliably operated.

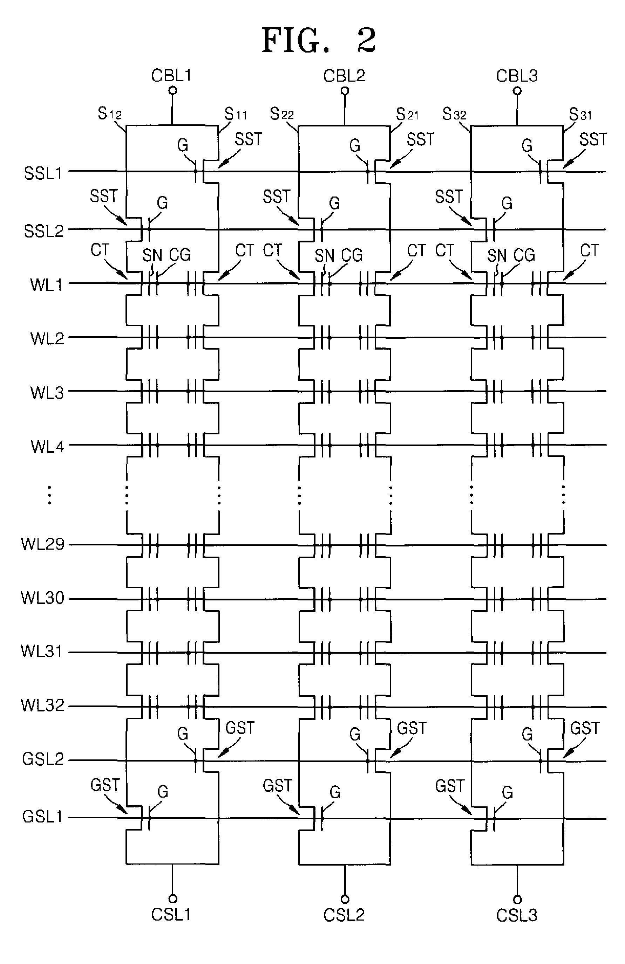

FIG. 2 is a circuit diagram illustrating a NAND-type nonvolatile memory device, according to another example embodiment. The example embodiment shown in FIG. 2 may be similar the example embodiment shown in FIG. 1, but arranged as an array. In example embodiments, like reference numerals denote like elements, and thus their description will not be repeated for the sake of brevity.

Referring to FIG. 2, the NAND-type nonvolatile memory device may include six strings S11, S12, S21, S22, S31 and S32. Adjacent pairs of first and second strings S11 and S12 may have one end connected to a first common bit line CBL1, and the other end connected to a first common source line CSL1. Other adjacent pairs of third and fourth strings S21 and S22 may have one end connected to a second common bit line CBL2, and the other end connected to a second common source line CSL2. Also, other adjacent pairs of fifth and sixth strings S31 and S32 may have one end connected to a third common bit line CBL3, and the other end connected to a third common source line CSL3.

The first, second and third common bit lines CBL1, CBL2 and CBL3 may refer to the common bit line CBL illustrated in FIG. 1, and the first, second and third common source lines CSL1, CSL2 and CSL3 may refer to the common source line CSL illustrated in FIG. 1. However, unlike in FIG. 2, a modified version of this example embodiment may have the first, second and third common source lines CSL1, CSL2 and CSL3 electrically connected to one another.

Each of the three pairs of strings (e.g., the first and second strings S11 and S12, the third and fourth strings S21 and S22, and the fifth and sixth strings S31 and S32) may refer to the pair of first and second strings S1 and S2 illustrated in FIG. 1.

Unit devices CT may be arranged in a NAND-cell array structure within the first through sixth strings S11, S12, S21, S22, S31 and S32. For example, the unit devices CT may be arranged in the rows and columns, and the unit devices CT in each row or string may be connected to one another in series. String selection transistors SST may be included between respective unit devices CT of the first through sixth strings S11, S12, S21, S22, S31 and S32 and the first, second and third common bit lines CBI1, CBL2 and CBL3. Source selection transistors GST may be included between respective unit devices CT of the first through six strings S11, S12, S21, S22, S31 and S32 and the first, second and third common source lines CSL1, CSL2 and CSL3.

The first string selection line SSL1 may be connected to the gates of the string selection transistors SST of the first string S11, the third string S21 and the fifth string S31. The second string selection line SSL2 may be connected to the gates G of the string selection transistors SST of the second string S12, the fourth string S22 and the sixth string S32.

In other words, the first string selection line SSL1 may be connected the gates G of the string selection transistors SST of one string out of each pair of strings S11 & S12, S21 & S22, or S31 & S32 connected to the first, second and third common bit lines CBL1, CBL2 and CBL3, respectively. The second string selection line SSL2 may be connected to the gates G of the string selection transistors SST of the other string out of each pair of strings S11 & S12, S21 & S22, or S31 & S32 connected to first, second and third common bit lines CBL1, CBL2 and CBL3, respectively.

The first source selection line GSL1 may be connected to the gates G of the source selection transistors GST of the second string S12, the fourth string S22 and the sixth string S32. The second source selection line GSL2 may be connected to the gates G of the source selection transistors GST of the first string S11, the third string S21 and the fifth string S31.

For example, the first source selection line GSL1 may be connected to the gates G of the source selection transistors GST of one string out of each pair of strings S11 & S12, S21 & S22 or S31 & S32 may be connected to the first, second and third common source lines CSL1, CSL2 and CSL3, respectively. The second source selection line GSL2 may be connected to the gates G of the source selection transistors GST of the other string out of each pair of strings S11 & S12, S21 & S22 or S31 & S32 connected to the first, second and third common source lines CSL1, CSL2 and CSL3, respectively.

In another example embodiment, the locations of the first string selection line SSL1 and the second string selection line SSL2 are interchangeable and may be reversed, and the locations of the first source selection line GSL1 and the second source selection line GSL2 are interchangeable and may be reversed.

The word lines WL1, WL2, WL3, WL4 ... WL29, WL30, WL31 and WL32 may be respectively connected to control gates CG of the unit devices CT located in the same row. The number of word lines shown in FIG. 2 is for illustrative purposes, and not to limit scope.

Furthermore, although six strings S11, S12, S21, S22, S31 and S32 are illustrated in FIG. 2, nonvolatile memory devices, according to at least this example embodiment, are not limited to such a number. Therefore, nonvolatile memory devices, according to example embodiments, may include greater than or equal to three pairs of strings according to the concept of FIG. 2.

A NAND-type nonvolatile memory device, according to another example embodiment, may include the first, second and third common bit lines CBL1, CBL2 and CB13 and the first, second and third common source lines CSL1, CSL2 and CSL3, so that the space between adjacent pairs of strings S11 & S12, S12 & S22 or S31 & S32 may be decreased thereby allowing higher integration.

A method of operating the NAND-type nonvolatile memory device, according to an example embodiment, will now be described. The operation of the NAND-type nonvolatile memory device, according to at least this example embodiment, may include programming, reading and/or block erasing. In a programming operation, data may be selectively stored in one of the plurality of unit devices CT of one of strings S11, S12, S21, S22, S31 and S32. In a reading operation, the data stored in one unit device CT of one string may be read. in block erasing operation, the data of the unit devices CT of the strings S11, S12, S21, S22, S31 and S32 may be erased, for example, simultaneously.

At least some or all operations, according to example embodiments, are the same or substantially the same as those of discussed above. In this example, operations discussed above with regard to one string may apply to other plurality of strings.

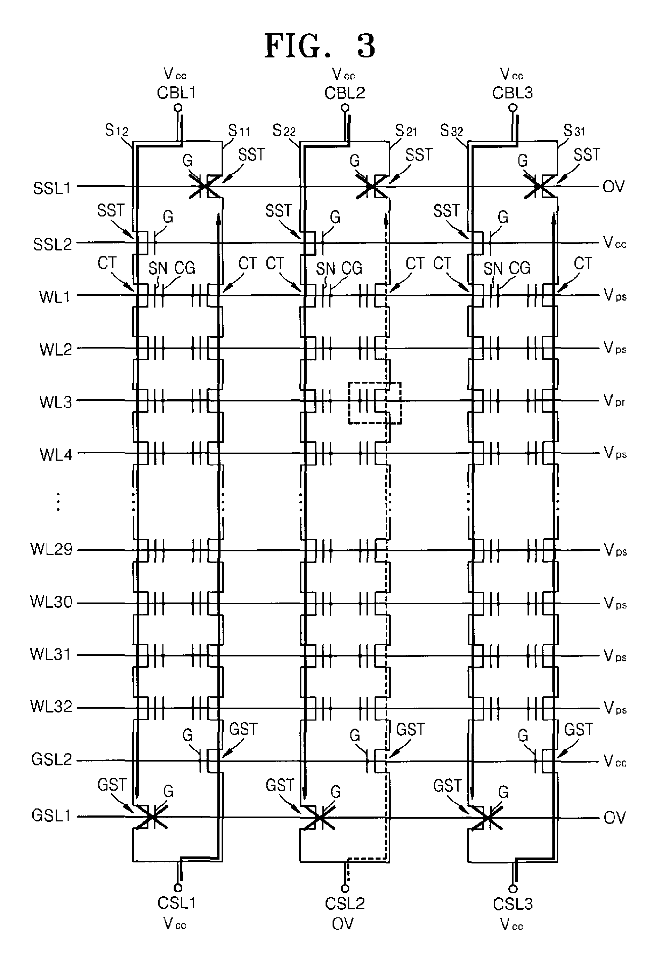

FIG. 3 is a circuit diagram illustrating a method of programming a NAND-type nonvolatile memory device, according to an example embodiment. Referring to FIG. 3, storing data in the unit device CT shown within the dotted line of the fifth row of the third string S21 will be described as an example. When programming, a low voltage (e.g., about 0V) may be supplied to the channels of the unit devices CT of the third string S21, and a high voltage (e.g., about V_{cc}) may be supplied to the channels of the unit devices CT of the other strings S11, S22, S31, S32 and S33. A program voltage (e.g., about Vₚᵣ) may be supplied to the third word line WL3, and a pass voltage (e.g., Vₚₛ) may be supplied to the other word lines WL1, WL2, WL4 ... WL29, WL30, WL31 and WL32. The channel or well regions of the unit devices CT may be optionally supplied with a low negative voltage.

The high voltage V_{cc} may be supplied to the first, second and third common bit lines CBL1, CBL2 and CBL3, and the first, third and fourth common source lines CSL1, CSL3 and CSL4. The low voltage of about 0V may be supplied (e.g., exclusively) to the second common source line CSL2. The turn-off voltage (e.g., about 0V) may be supplied to the first string selection line SSL1, and the turn-on voltage (e.g., about V_{cc}) may be supplied to the second string selection line SSL2. Also, the turn-off voltage (e.g., about 0V) may be supplied to the first source selection line GSL1, and the turn-on voltage (e.g., about V_{cc}) may be supplied to the second source selection line GSL2.

By doing so, all or substantially all string selection transistors SST connected to the first string selection line SSL1 and all or substantially all source selection transistors GST connected to the first source selection line SSL1 may be turned off (denoted by "X" in FIG. 3). Whereas, all or substantially all string selection transistors SST connected to the second string selection line SSL2 and all or substantially all source selection transistors GST connected to the second source selection line GSL2 are turned on.

Accordingly, the low voltage (e.g., about 0V) as denoted by the dotted line may be supplied to the channels of the unit devices CT of the third string S21 selected for programming. Meanwhile, the channels of the unit devices CT of the other strings S11, S12, S22, S31 and S32 resistant to programming may be supplied with the high voltage V_{cc} as denoted by a solid line. As a result, programming may be performed in the unit device CT in the fifth row of the third string S21, of which the gate G is supplied with the program voltage Vₚᵣ and the channel is supplied with the low voltage of about 0V.

According to another example embodiment, as described with reference to the operating method of the above-discussed example embodiment, the high voltage V_{cc} may be supplied to the first, second and third common source lines CSL1, CSL2 and CSL3 and the first and third common bit lines CBL1 and CBL3, and the low voltage (e.g., about 0V) may be supplied to the second common bit line CBL1. Thus, data may be stored in the unit devices CT of the third string S21 denoted by the dotted line. In this example, the first, second and third common source lines CSL1, CSL2 and CSL3 are electrically connected, and the high voltage V_{cc} may be supplied (e.g., simultaneously) to the first, second and third common source lines CSL1, CSL2 and CSL3. Otherwise, the programming operation may be performed in the same or substantially the same as in the above-discussed example embodiments, and thus will not be repeated for the sake of brevity.

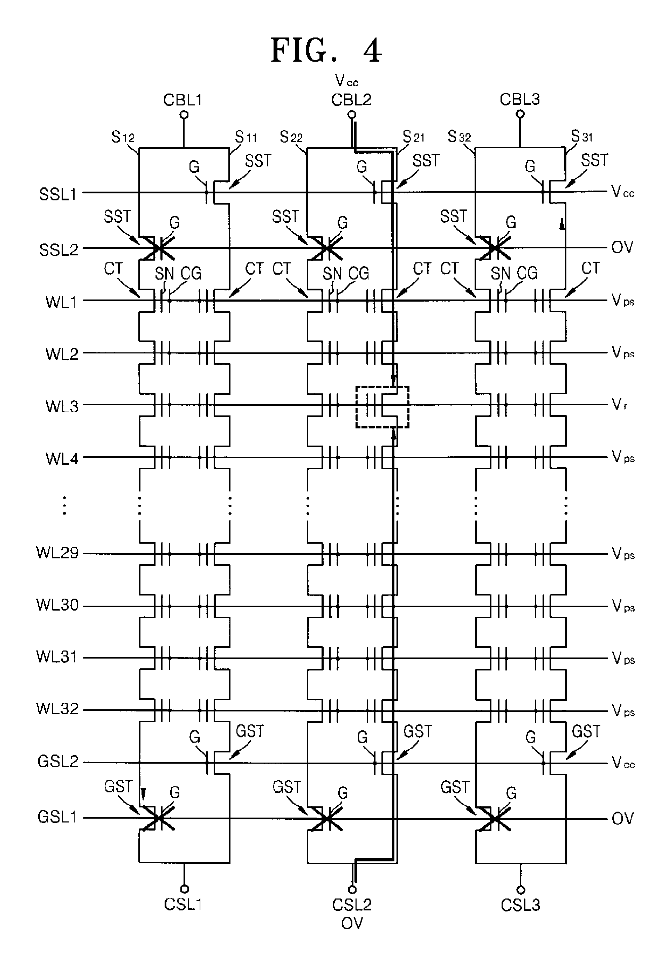

FIG. 4 is a circuit diagram illustrating a method of reading the NAND-type nonvolatile memory device, according to an example embodiment. Referring to FIG. 4, reading data from a unit device CT of a fifth row of the third string 21 will be discussed for example purposes. The high voltage V_{cc} may be supplied to the second common bit line CBL2, and the low voltage (e.g., about 0V) may be supplied to the second common source line CSL2. The reading voltage (e.g., Vᵣ) may be supplied to the selected third word line WL3, and the pass voltage Vₚₛ may be supplied to the other word lines WL1, WL2, WL4 ... WL29, WL30, WL31 and WL32. The operation with respect to the string selection lines SSL1 and SSL2 and the source selection lines GSL1 and GSL2 may be the same or substantially the same as the programming described above with regard to FIG. 3.

According to this example embodiment, the current flowing from the second common bit line CBL2 toward the second common source line CSL2 through the third string S21 may vary depending on the state of the unit devices CT of the fifth row of the third string S21.

According to at least this example embodiment, the pairs of strings S11 & S12, S21 & S22 or S31 & S32 connected to the first, second and third common bit lines CBL1, CBL2 and CBL3 and the first, second and third common source lines CSL1, CSL2 and CSL3 may be separated, and thus, may be individually and/or more reliably operated.

While example embodiments have been particularly shown and described with reference to the example embodiments shown in the drawings, it will be understood by those of ordinary skill in the art that various changes in form and detail may be made therein without departing from the scope of the present invention as defined by the following claims.

## Claims

1. A nonvolatile memory device comprising:
a first pair of strings including,
a first string having a first string selection transistor, a plurality of first unit devices and a first source selection transistor connected in series;
a second string having a second string selection transistor, a plurality of second unit devices, and a second source selection transistors connected in series;
a plurality of word lines, each word line being connected to a control gate of a first unit device and a control gate of a corresponding second unit, the first and corresponding second unit device being located in a same row of the first string and the second string;
a first common bit line connecting one end of each of the first string and the second string; and
a first common source line connecting another end of the first string and the second string.

2. The nonvolatile memory device of claim 1, the device further including,
a first string selection line connected to a gate of the first string selection transistor, and
a second string selection line connected to a gate of the second string selection transistor.

3. The nonvolatile memory device of claim 2, wherein the first string selection line and the second string selection line traverse the first and second strings in different rows.

4. The nonvolatile memory device of any preceding claim, the device further including,
a first source selection line connected to a gate of the first source selection transistor, and
a second source selection line connected to a gate of the second source selection transistor.

5. The nonvolatile memory device of claim 4, wherein the first source selection line and the second source selection line traverse the first and second strings in different rows.

6. The nonvolatile memory device of any preceding claim, wherein at least one of the plurality of first unit devices and the plurality of second unit devices have a unit cell structure of a flash memory device or a Silicon-Oxide-Nitride-Oxide-Silicon (SONOS) memory device.

7. The nonvolatile memory device of claim 1, further including,
at least one second pair of strings, the second pair of strings including,
a third string including a third string selection transistor, a plurality of third unit devices and a third source selection transistor connected in series, and
a fourth string including a fourth string selection transistor, a plurality of fourth unit devices, and a fourth source selection transistors connected in series;
at least one second common bit line connecting one end of each of the third string and the fourth string; and
at least one second common source line connecting another end of the third string and the fourth string, wherein
each of the plurality of word lines are connected to a control gate of the first unit device, a control gate of a corresponding second unit device, a control gate of the corresponding third unit device and a control gate of a corresponding fourth unit device, the corresponding first, second, third and fourth unit devices being located on the same row of the first, second, third and fourth string, respectively.

8. The nonvolatile memory device of claim 7, wherein the first string selection line is connected to a gate of the third string selection transistor, and the second string selection line is further connected to a gate of the fourth string selection transistor.

9. The nonvolatile memory device of claim 8, wherein the first string selection line and the second string selection line traverse the first and second strings in different rows, and the third string selection line and the fourth string selection line traverse the third and fourth strings in different rows.

10. The nonvolatile memory device of claim 7, 8 or 9, wherein the first source selection line is further connected to a gate of the third source selection transistor and the second source selection line is further connected to a gate of the fourth source selection transistor.

11. The nonvolatile memory device of any of claims 7 to 10, wherein the first string selection line and the second string selection line are arranged in different rows.

12. The nonvolatile memory device of any of claims 7 to 11, wherein the plurality of unit devices have a unit cell structure of a flash memory device or a SONOS (Silicon-Oxide-Nitride-Oxide-Silicon) memory device.

13. The nonvolatile memory device of any of claims 7 to 12, wherein the plurality of common source lines are electrically connected to one another.

14. A method of operating a nonvolatile memory device, the method comprising:
selectively storing data in one of a plurality of unit devices of a first pair of strings by supplying a first voltage to a channel of a plurality of unit devices of a first string, supplying a second voltage to a channel of a plurality of unit devices of a second string, supplying a third voltage to a word line connected to a gate of the one of the plurality of unit devices in which data is to be stored, and supplying a fourth voltage to word lines connected to gates of the other of the plurality of unit devices; and
reading data stored in the one of the plurality of unit devices; wherein the first and the second voltage are different.

15. The method of claim 14, wherein the first voltage enables selective storing of data in the one of the plurality of unit devices, and the second voltage prevents selective storing of data in the other of the plurality of unit devices.

16. The method of claim 14 or 15, wherein the selectively storing further includes,
supplying the second voltage to one of a common bit line connecting one end of each of the first string and the second string a common source line connecting another end of the first string and the second string, and supplying the first voltage the other of the common source line and the common bitline,
supplying a turn-off voltage to a string selection line connected to a gate of the string selection transistor of the first string, and supplying a turn-on voltage to a string selection line connected to the string selection transistor of the second string, and
supplying the turn-on voltage to a source selection line connected to a gate of the source selection transistor of the first string, and supplying a turn-off voltage to a source selection line connected to the string selection transistor of the second string.

17. The method of any of claims 14 to 16, wherein the reading includes,
supplying the second voltage to one of a common bit line connecting one end of each of the first string and the second string a common source line connecting another end of the first string and the second string, and supplying the first voltage the other of the common source line and the common bitline,
supplying the turn-on voltage a string selection line connected to a gate of the string selection transistor of the first string, and supplying a turn-on voltage to a string selection line connected to the string selection transistor of the second string;
supplying the turn-on voltage to the source selection line connected to a gate of the source selection transistor of the first string, and supplying a turn-off voltage to a source selection line connected to the string selection transistor of the second string;
supplying the turn-off voltage to the string selection line connected to the gate of the string selection transistor of the second string and to the source selection line connected to the gate of the source selection transistor of the second string; and
supplying a read voltage to the word line connected to a gate of one of the plurality of unit devices of the first string, and supplying a pass voltage to the word lines connected to gates of the other of the plurality of unit devices.

18. The method of any of claims 14 to 17, further including,
block erasing data of the plurality of unit devices of the first string and the second string.

19. The method of claim 18, wherein the block erasing is performed simultaneously.

20. The method of any of claims 14 to 19, wherein the first voltage is lower than the second voltage.
